# EUROPEAN PATENT APPLICATION

(11) **EP 1 432 029 A2**
(43) Date of publication of application: **23.06.2004**
(21) Application number: 03257751.2
(22) Date of filing: 10.12.2003
(51) Int. Cl.: H01L 23/373, H01L 21/48

(54) **Package for housing a semiconductor chip having a metal-diamond composite in the substrate, and fabrication method thereof**

(30) Priority: 18.12.2002 JP 2002366165
(71) Applicant: SUMITOMO ELECTRIC INDUSTRIES, LTD., Osaka-shi, Osaka (JP); A.L.M.T. Corp., Tokyo (JP)
(72) Inventor: Saito, Hirohisa c/o Itami Works of Sumitomo, Itami-shi Hyogo (JP); Tsuno, Takashi c/o Itami Works of Sumitomo, Itami-shi Hyogo (JP); Kawai, Chihiro c/o Itami Works of Sumitomo, Itami-shi Hyogo (JP); Nishida, Shinya c/o Toyama Works of A.L.M.T. Corp,, Toyama (JP); Tanaka, Motyoshi c/o Itami Works of Sumitomo, Itami-shi Hyogo (JP)
(74) Representative: Cross, Rupert Edward Blount

(57) **Abstract**

The present invention provides an economical package for housing semiconductor chip that allows a semiconductor chip to operate normally and stably over long periods by efficiently transferring heat generated during the operation of the semiconductor chip to the package mount substrate.

A package for housing semiconductor chip that has a substrate, whose upper face is provided with a mounting space whereon a semiconductor chip is mounted, and whose opposite sides are provided with a screw mounting part which is a through-hole or notch; a frame, which is provided on the upper face of the substrate so as to enclose the mounting space and whose side or top has a joint for an input/output terminal; and an input/output terminal, which is connected to the joint, wherein at least a portion of the substrate below the semiconductor chip mounting space thereof comprises a metal-diamond composite that is produced by infiltrating a base material in which diamond grains are joined via a metal carbide with a metal containing copper and/or silver as the main component, and the other part including the screw mounting part consists of metal.
The metal-diamond composite can be formed in an external mould or directly in the substrate. The sizes of the diamond grains can be varied over the composite to adapt the thermal expansion.

## Description

### BACKGROUND OF THE INVENTION

### 1. Field of the Invention

The present invention relates to a package for housing semiconductor integrated circuit chips such as ICs and LSIs, as well as field effect transistors (FET: Field Effect Transistor) or a variety of other semiconductor chips, and more particularly to a package for housing a semiconductor chip used in high power, high frequency transistors and power amplifiers for electrical/electronic components in telecommunication base station, as well as to a semiconductor device employing this package for housing semiconductor chip.

### 2. Description of the Related Art

A wireless semiconductor package, which is one type of conventional package for housing semiconductor chip (referred to as semiconductor package hereinbelow), is formed such that a thermal diffusion substrate is mounted on a rectangular parallelepiped-shaped metal substrate and a semiconductor chip is mounted atop the thermal diffusion substrate.

According to the enhanced output of semiconductor chips in recent years, the applied power has increased, and the amount of heat generated has also steadily increased. Accordingly, measures have been taken to improve the performance about cooling chips by adopting a high thermal conductive material such as a Cu or Cu-W composite material for the metal substrate and heat-spreasing substrate. More particularly, where the most recent forms of package are concerned, a package produced by forming a ceramic wall on a Cu-W composite alloy substrate so that this ceramic wall encloses the semiconductor chip, and then mounting an input/output terminal on this ceramic wall has become mainstream.

This type of package is introduced in Japanese Patent Publication No. H4-65544B. According to the description in this publication, in a thermal conductive substrate consisting of a copper-tungsten and/or copper-molybdenum composite material, by using a composite material whose copper content is equal to or less than 30% mass as the thermal conductive substrate, the ceramic, which constitutes a package circumferential member, is not damaged. And, by using a composite material whose copper content is equal to or less than 25% mass, practical use is unproblematic even when the thermal conductive substrate and circumferential member that consists of ceramic are directly connected by brazing material.

In addition, Japanese Patent Publication No. 2002-121639A reports on a procedure for optimizing Young's modulus while retaining the thermal conductivity by adjusting the amount of ferrous metal contained in addition to controlling the amount of copper in the material. Because, in a thermal conductive substrate consisting of a copper-tungsten and/or copper-molybdenum composite material, when the copper content is less than 25% mass, the rigidity of the substrate itself increases. Consequently, in the case of a package with a large heat-generating chip in particular, when a considerably thick brazing material layer or stress alleviation layer is not interposed between the connecting sections of the package, this layer sometimes does not withstand the heat-cycles during application.

Japanese Patent Publication No. 2001-244357A introduces a semiconductor housing package where the stress is laid on economic efficiency while at the same time ensuring high thermal conductivity by applying a diamond and/or diamond-coated substrate only directly below the semiconductor chip mounting space.

However, the amount of heat that is generated during operation, in depending on the further enhancements of the output of semiconductor chips in recent years is gradually increasing, and this heat builds up rather than being diffused. As a result, the operability of the semiconductor chip is compromised, and there is the problem of thermal degradation. As means for resolving this problem, although consideration may also be paid to adding cooling equipment to the outside and increasing the size to raise the thermal conduction efficiency, in this case, the electrical power consumption of the enclosure for housing the semiconductor package increases or the enclosure is enlarged, which represents a deviation from the recent trend toward miniaturization, a lighter weight and reduced electrical power consumption.

Further, a package employing a diamond and/or diamond thin film substrate is highly effective in spreading heat generated locally by the semiconductor chip. However, the possibility exists that the performance of cooling chips will be inferior to the increased amount of heat generation in the future, particularly in a system in which heat is diffused (conducted) to the outside of the package, because this package has a constitution in which a substrate whose thermal conductivity is inferior to that of diamond and a diamond thin film substrate is disposed. In addition, with regard to a monocrystalline diamond that is larger than the semiconductor chip or a monocrystalline/polycrystalline diamond formed by chemical vapor deposition (CVD), and a diamond thin film substrate formed by chemical vapor deposition, the synthesis costs and the costs involved in machining the shape of the substrate surface to a level permitting the semiconductor chip to be mounted thereon cannot be adequately cut, and hence, from an economical perspective, usage is restricted to special applications.

These problems are not limited to the above semiconductor package, being equally related to semiconductor packages that allow the substrate to function as a heat spreading plate and that house semiconductor integrated circuit chips such as ICs and LSIs, as well as FETs or a variety of other semiconductor chips.

### SUMMARY OF THE INVENTION

Accordingly, the present invention was completed in view of the foregoing problems, an object thereof being to provide an economical package for housing semiconductor chip that allows a semiconductor chip to operate normally and stably over long periods by efficiently transferring heat generated during the operation of semiconductor integrated circuit chips such as ICs and LSIs, as well as a variety of semiconductor chips such as FETs, LDs, LEDs and PDs, and particularly high-power, high frequency transistors, to the package mount substrate.

The present invention was completed when, as a result of the present inventors carrying out a thorough investigation, they discovered that the above problems can be resolved by enhancing the substrate, the constitution of this invention being as follows:

(1) A package for housing semiconductor chip comprising:
a substrate, whose upper face is provided with a mounting space whereon a semiconductor chip is mounted, and whose opposite sides are provided with a screw mounting part that is a through-hole or notch, and at least a portion of the substrate below the mounting space comprising
   a metal-diamond composite comprising diamond grains,
   a metal carbide covering a surface of the diamond grains, and
   a metal containing silver and/or copper as a main component and laying between the diamond grains by infiltrating therebetween, and
   wherein, a remaining part that includes the screw mounting part consists of a metal;
a frame on the upper face of the substrate so as to surround the mounting space, the frame having a joint for an input/output terminal at a side or top thereof; and
an input/output terminal being connected to the joint.

(2) A package for housing semiconductor chip according to (1) above, wherein at least a portion of a surface of said substrate comprising the metal and the metal-diamond composite, and/or a portion of a surface of said frame, and/or a portion of a surface of said input/output terminal is plated with gold.

(3) A package for housing semiconductor chip according to (1) or (2) above, wherein the metal of the substrate, which comprises the metal and the metal-diamond composite, is a metal or a metal alloy containing at least one element selected from Cu, Fe, Mo, W, Ni, Co and Cr.

(4) A package for housing semiconductor chip according to any of (1) to (3) above, wherein a thermal expansion coefficient of the metal of said substrate, which comprises the metal and the metal-diamond composite, is the same as or greater than a thermal expansion coefficient of the metal-diamond composite.

(5) A package for housing semiconductor chip according to any of (1) to (4) above, wherein a method for joining said metal and said metal-diamond composite is brazing.

(6) A package for housing semiconductor chip according to any of (1) to (4) above, wherein a method for joining said metal and said metal-diamond composite is a method involving diffusion of the metals.

(7) A package for housing semiconductor chip according to any of (1) to (4) above, wherein a method for joining said metal and said metal-diamond composite is tight-fit bonding.

(8) A package for housing semiconductor chip according to any of (1) to (7) above, wherein an average grain diameter of the diamond grains is 10 to 700 µm.

(9) A package for housing semiconductor chip according to any of (1) to (8) above, wherein an average grain diameter of the diamond grains is 50 to 700 µm at the center of the metal-diamond composite and 10 to 60 µm at the circumference thereof.

(10) A semiconductor device comprising:
the package for housing semiconductor chip according to any of (1) to (9) above;
a semiconductor chip being mounted on and fixed to the mounting space; and
a lid being joined to an upper face of the frame.

(11) A method for fabricating a package for housing semiconductor chip comprising:
inserting a metal-diamond composite into part of a hole in a metal substrate provided with a hole, the metal-diamond composite comprising diamond grains whose surface is covered with a metal carbide and a metal containing silver and/or copper as a main component and the metal laying between the diamond grains by infiltrating therebetween; and
joining the metal substrate and the metal-diamond composite together to form a substrate;
providing a mounting space to mount a semiconductor chip on an upper face of the substrate;
providing a screw mounting part that is a through-hole or notch at opposite sides of the substrate; and
assembling the substrate, a frame to be on the upper face of the substrate so as to surround the mounting space and having a joint for an input/output terminal at a side or top thereof, and an input/output terminal to be connected to the joint.

(12) A method for fabricating a package for housing semiconductor chip comprising:
filling diamond grains, a powder of a metal containing copper and/or silver as a main component and a powder of a metal used to form a carbide, into a hole in a metal substrate provided with a hole;
packing a mixture of the diamond grains and the metal powders so that the diamond grains and the metal powders are distributed at a uniform density;
heating the packed mixture so as to form a metal-composite in which a carbide covers a surface of the diamond grains, and to join the metal-diamond composite and the metal substrate together to form a substrate, by allowing the metal containing copper and/or silver as a main component to infiltrate a gap in the powders;
providing a mounting space to mount a semiconductor chip on an upper face of the substrate;
providing a screw mounting part that is a through-hole or notch at opposite sides of the substrate; and
assembling the substrate, a frame to be on the upper face of the substrate so as to surround the mounting space and having a joint for an input/output terminal at a side or top thereof, and an input/output terminal to be connected to the joint;

(13) A method for fabricating a package for housing semiconductor chip comprising:
press-molding a diamond grains, a powder of a metal containing copper and/or silver as a main component and a powder of a metal used to form a carbide, so as to form a temporary molded body in which the diamond grains and the metal powders are distributed at a uniform density;
filling the temporary molded body into a hole in a metal substrate provided with a hole;
allowing the powder of a metal containing copper and/or silver as a main component to infiltrate the temporary molded body so as to form a metal-diamond composite in which a carbide covers a surface of the diamond grains, and to join the metal-diamond composite and the metal substrate together, for obtaining a substrate;
providing a mounting space to mount a semiconductor chip on an upper face of the substrate;
providing a screw mounting part that is a through-hole or notch at opposite sides of the substrate; and
assembling the substrate, a frame to be on the upper face of the substrate so as to surround the mounting space and having a joint for an input/output terminal at a side or top thereof, and an input/output terminal to be connected to the joint.

(14) A method for fabricating a package for housing semiconductor chip according to (13) above, wherein the temporary molded body is sandwiched between a molded bodies of the powder of a metal containing copper and/or silver as a main component, and then the metal containing copper and/or silver as a main component is allowed to infiltrate the temporary molded body by heating.

According to the constitution in (1) and (2) above, the semiconductor package can be rigidly bonded to an external electrical circuit, and, even when the amount of heat generated during operation of the semiconductor chip is extremely large, this heat can be efficiently transferred to a heat sink, and, by forming a gold plated layer, which is a stable material, degradation with respect to humidity and so forth can also be suppressed, and the semiconductor chip housed within the semiconductor package can be allowed to operate normally and stably over long periods.

As for the substrate that comprises a metal and a metal-diamond composite, because a metal or metal alloy including at least one element of Cu, Fe, Mo, W, Ni, Co and Cr is used as the metal, a raw material cost reduction greater than when the whole body is the metal-diamond composite can be achieved. Furthermore, metal machining in which the workability of the external form that is also generally used can be applied. A reduction in the machining costs as well as a shortage of the machining time can be achieved by omitting the special machining steps arising from the inclusion of diamond, then a package cost reduction is possible.

In the package of the present invention, because the thermal expansion coefficient of the metal of the substrate comprising a metal and a metal-diamond composite is the same as or larger than the thermal expansion coefficient of the metal-diamond composite, cracks do not occur at the interface between the metal of the substrate and the metal-diamond composite, even though a temperature rises when joining the semiconductor chip to the mounting space of the substrate by using a gold solder and the temperature drops after mounting.

Moreover, according to the package of the present invention, because brazing is employed as the method for joining the metal portion of the substrate comprising a metal and a metal-diamond composite, with the metal-diamond composite, a rigid join can be achieved.

In the package of the present invention, because the method for joining the metal-diamond composite to the metal portion of the substrate which comprises a metal and a metal-diamond composite is implemented via the diffusion of the metals, a rigid join can be achieved. And, the characteristics such as the thermal expansion coefficient close to the end of the interface, the thermal conductivity, and so forth, are the intermediate characteristics of the metal and the metal-diamond composite. A concentration of thermal stress can also be alleviated with respect to temperature variations due to the rise and fall in temperature during mounting of the semiconductor chip, thermal shock, temperature cycle tests and so forth.

About the package of the present invention, the method for joining the metal-diamond composite to the metal section of the substrate which comprises a metal and a metal-diamond composite permits a rigid join by means of tight-fit bonding.

In the package of the present invention, because the average grain diameter of a diamond grain is 10 to 700 µm, the metal-diamond composite can be afforded a moderate thermal expansion coefficient. When this diameter is less than 10 µm, a sufficient thermal conductivity is not obtained because a multiplicity of diamond grains lining up in the thermal conduction path from the upper face of the substrate to the bottom face thereof and an increase in the metal layer lying between the grains is caused. Meanwhile, when the average grain diameter is larger than 700 µm, only one or two diamond grains can be included when the thickness of the substrate is about 1.4 mm, and the thermal expansion coefficient of the metal-diamond composite is close to the thermal expansion coefficient of diamond, meaning that the difference from the thermal expansion coefficient of the semiconductor chip being mounted is large.

Furthermore, in the package of the present invention, by making the average grain diameter of the diamond grains 50 to 700 µm at the center of the metal-diamond composite and 10 to 60 µm at the circumference, the thermal conductivity can be raised and damage to the metallic mold can be reduced. That is, by arranging diamond grains of a relatively large diameter at the center, the thermal conductivity can be raised. Also, by arranging diamond grains of a relatively small diameter at the circumference, damage to the metallic mold in the process of manufacturing the metal-diamond composite can be reduced and surface roughness in the vicinity of the upper and lower faces of the substrate can be diminished.

Moreover, a semiconductor device of the present invention is equipped with the above-described package for housing semiconductor chip of the present invention; a semiconductor chip, which is mounted on and fixed to the mounting space and electrically connected to the input/output terminal; and a lid that is joined to the upper surface of a frame, whereby a highly reliable semiconductor device employing the semiconductor package can be provided.

### BRIEF DESCRIPTION OF THE DRAWINGS

Fig. 1 is a perspective view of an example of the package for housing semiconductor chip of the present invention.

Fig. 2 provides a top view and cross-sectional view of the package for housing semiconductor chip in Fig. 1.

Fig. 3 is an upper view of the parts of the package for housing semiconductor chip in Fig. 1.

Fig. 4 is an enlarged cross-sectional view of the metal-diamond composite.

Fig. 5 shows an example of the fabrication method for the metal-diamond composite in the present invention.

Fig. 6 shows an example of the fabrication method for the metal-diamond composite according to the present invention;

Fig. 7 shows the state of the join between the substrate and metal-diamond composite when a tapered hole is provided in the substrate.

Fig. 8 shows the state of the join between the metal and the metal-diamond composite.

### DETAILED DESCRIPTION OF THE PREFERRED EMBODIMENTS

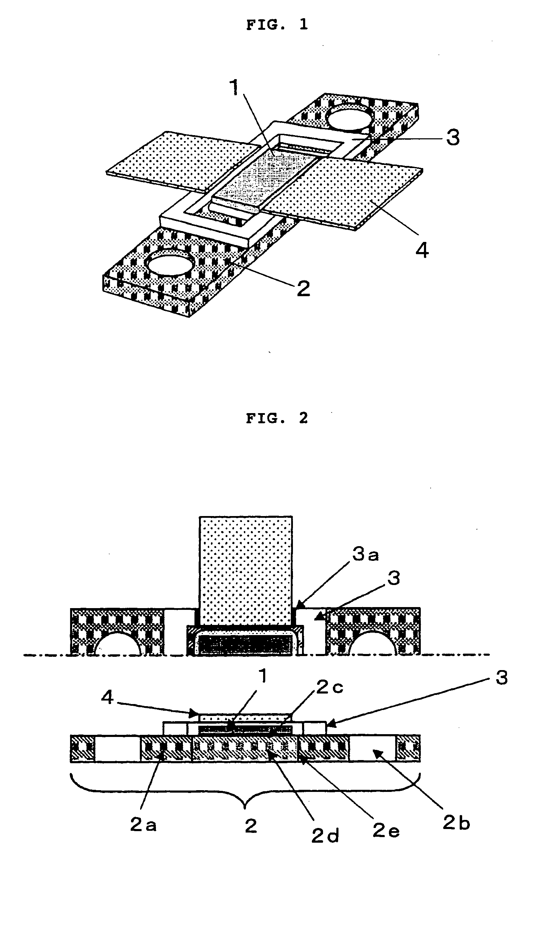

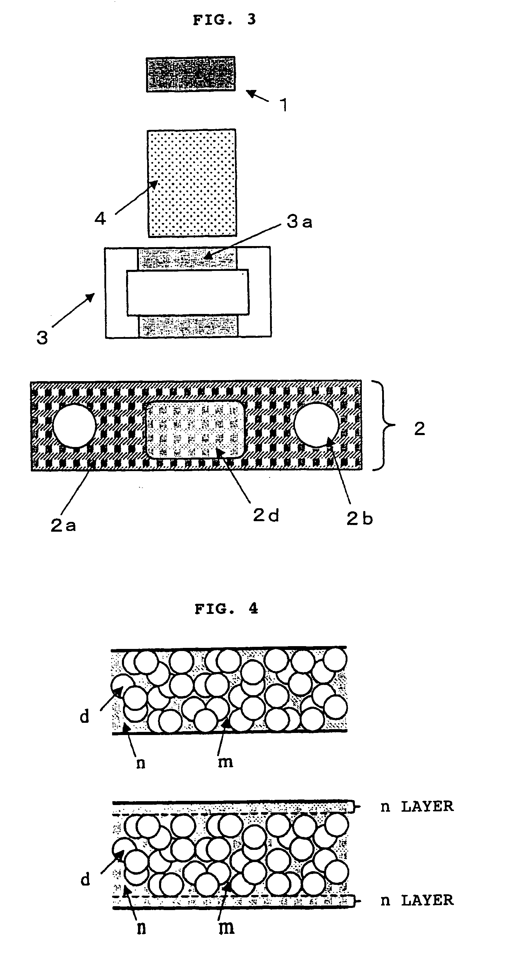

The package for housing semiconductor chip according to the present invention will be described in detail below. Figs. 1 to 3 show an example of the embodiment of the semiconductor package of the present invention. Fig. 1 is a perspective view of the semiconductor package, Fig. 2 provides a top view and cross-sectional view of the substrate of the semiconductor package, and Fig. 3 is an upper view of the parts of the semiconductor package.

In Figs. 1 to 3, 1 is a semiconductor chip that is mounted on and fixed onto a section 2d that is formed from the metal-diamond composite of a substrate 2. 2 is the substrate, 3 is a frame, and 4 is an input/output terminal that is connected to a joint 3a of the frame 3, the container for housing the semiconductor chip being mainly constituted by the substrate 2, the frame 3, and the input/output terminal 4. In the substrate 2, 2a denotes the metal portion, 2b denotes the screw mounting part, 2c denotes the semiconductor chip mounting space, and 2d denotes the metal-diamond composite.

Moreover, Fig. 4 is an enlarged cross-sectional view of the metal-diamond composite, the metal-diamond composite comprises diamond grains d, metal carbide m, and a metal n that contains copper and/or silver as a main component. The surface of the metal-diamond composite preferably has a gold plated layer (n layer) deposited thereon.

The thermal expansion coefficient of the metal-diamond composite employed by the present invention is 5 to 10×10⁻⁶/°C as a result of the metal-diamond composite being infiltrated with a metal whose principal constituent(s) is(are) copper and/or silver. Copper and/or silver is used as the metal with which the metal-diamond composite is infiltrated because of virtue of the characteristics of copper and/or silver, the thermal expansion coefficient being 17 to 20×10⁻⁶/°C, the thermal conductivity being not less than 390 W/m·K, the modulus of elasticity being not less than 80 GPa, and the melting point being not less than 900 °C. These characteristics are preferable from the perspective of the fabrication and characteristics of the semiconductor package.

Describing this specifically, where the thermal expansion coefficient is concerned, if the base matrix in which diamond grains are joined via a metal carbide is infiltrated at an appropriate volume with a metal containing copper and/or silver as the main component, the thermal expansion coefficient of the metal-diamond composite does not rise to an extent where same differs greatly from that of the semiconductor chip. Moreover, there is the advantage that the heat generated during operation of the semiconductor chip is transmitted because the thermal conductivity of copper and silver is extremely high.

In addition, because the melting point of the metal whose principal component is copper and/or silver is extremely high, no melting of the semiconductor package occurs even when same is assembled by means of silver brazing material or another brazing material with a melting point of about 780 °C or more. And, the inside of the matrix in which diamond grains are joined via metal carbide can thus always be stabilized. On the other hand, when a metal that melts at the abovementioned temperature is used, the metal sometimes melts and escapes from the end faces of the substrate and the frame, and hence this kind of metal is not suitable as a material to be used for the semiconductor package.

Methods for constituting part of the substrate with the metal-diamond composite include such as a method involving the fitting of a pre-fabricated metal-diamond composite in a hole provided in the substrate, or producing the metal-diamond composite within the hole provided in the substrate. Although outlines of fabrication examples are illustrated below, the method for fabricating the metal-diamond composite according to the present invention is not limited to or by the following fabrication examples.

### (Fabrication example A)

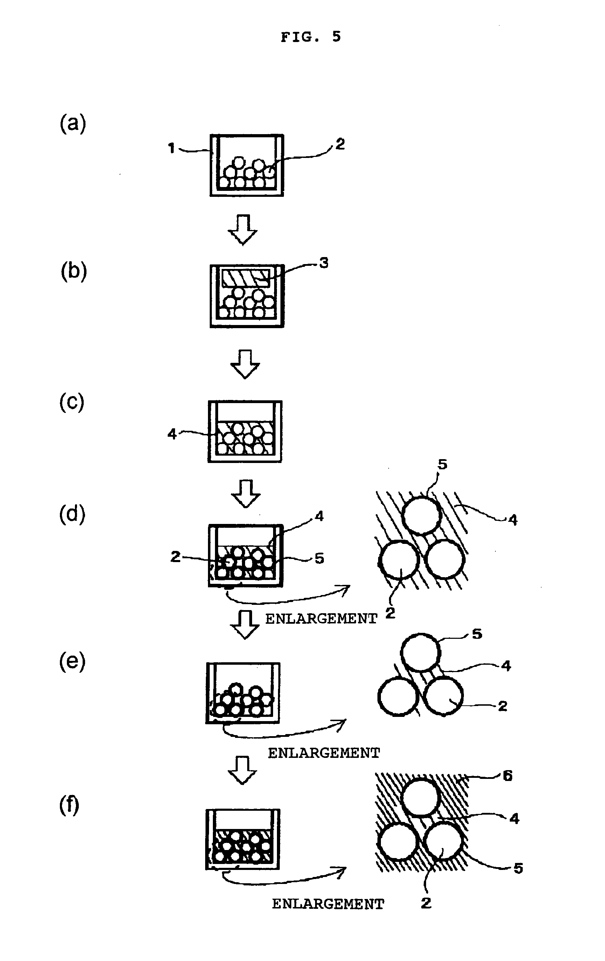

This fabrication example is illustrated on the basis of Figs. 5(a) to 5(f).
First of all, as shown in Fig. 5(a), diamond grains 2 are packed into a container 1. Next, a metal block 3 is provided so as to make contact with the diamond grains 2 as shown in Fig. 5(b). The metal block 3 is an alloy containing at least one element selected from the Groups 4a to 6a (a metal component serves as the metal carbide) and at least one element selected from Ag, Cu, Au, Al, Mg and Zn. The metal component of the metal carbide is, in addition to Ti, particularly preferably Zr, Hf. A smaller quantity of the metal forming the carbide is preferable in terms of the thermal characteristics. However, if this quantity is too small, the effects are not yielded. For this reason, the quantity of the metal forming the metal carbide is preferably such that the thickness of the carbide reaction layer formed on the diamond grain surface is 0.01 to 1.0 µm.

Next, as shown in Fig. 5(c), the metal block 3 is heated so that same melts, and, when the molten metal 4 has infiltrated between the diamond grains 2, a metal carbide 5 is formed on the surface of the diamond grains 2 as a result of the Ti contained in the molten metal 4 reacting with the diamond 2, as shown in Fig. 5(d).

Thereafter, the materials are heated in a vacuum, whereby, the metal 4 is caused to evaporate until gaps are established between the diamond grains. As shown in Fig. 5(e), gaps are opened between the diamond grains 2 and a state where the diamond 2, the metal carbide 5 and part of the metal 4 remains is formed.

Next, for the purpose of filling the gaps between the diamond grains 2, a metal block of a metal containing at least one element selected from Ag, Cu, Au, Al, Mg and Zn is placed into a container and then held under reduced pressure and heated such that the metal melts, and, as shown in Fig. 5(f), permeates the gaps between the diamond grains 2 so as to fill the gaps. After the metal 6 that has thus permeated the gaps has solidified, the container is removed, whereby a metal-diamond composite can be obtained.

### (Fabrication example B)

First of all, a mixed powder that comprises diamond grains, a powder of metal 1 composed of one or more element(s) selected from Ag, Cu, Au, Al, Mg and Zn, and a powder of a metal 2 composed of one or more element(s) selected from Groups 4a, 5a and 6a is prepared. Or, a mixed powder comprises diamond grains and an alloy powder of metal 1 and metal 2 is prepared. This mixed powder is pressure-molded to obtain a mixed powder molded body. On the other hand, a powder of a metal 3 that is composed of one or more element(s) selected from Ag, Cu, Au, Al, Mg and Zn is pressure-molded to obtain a metal powder molded body. The metal powder molded body is disposed on top of the mixed powder molded body, and, in a non-oxidizable atmosphere, the two molded bodies are held in contact with each other while being heated at or above the melting point of metal 3 such that the carbide of metal 2 is formed on the diamond grain surface, and the molten metal 3 infiltrates the gaps between the diamond grains in an unloaded state to form a dense body, whereby the metal-diamond composite is obtained.

Here, metal 1 and metal 3 do not need to be a simple substance, but may instead be a metal whose main constituent is any of Ag, Cu, Au, Al, Mg, and Zn. Metal 2 doesn't need to be a simple substance either, and instead may be a compound whose main component is one element selected from the Groups 4a, 5a and 6a. Metal 1 and metal 3 may be the same metal or may be different metals.

The metal-diamond composites thus obtained by the above-described fabrication methods A and B both have a structure that comprises diamond grains, whose surface is covered with the metal carbide, and a metal whose main component is silver and/or copper lies between the diamond grains. The metal-diamond composite used in the first to third Examples was produced by the fabrication method B.

Furthermore, with regard to the method that involves fabricating the metal-diamond composite within the hole provided in the substrate, although described in Examples 4 to 8, an outline of this fabrication example is described below.

### (Fabrication example C)

First, a mixed powder that comprises diamond grains, a powder of metal 1 composed of one or more element(s) selected from Ag, Cu, Au, Al, Mg and Zn, and a powder of metal 2 composed of one or more element(s) selected from Groups 4a, 5a and 6a is made to fill the hole provided in the substrate. The diamond grains and the metal powders are packed in the hole by a press so as to establish a uniform density. In this case, a metal 3 composed of at least one element selected from Ag, Cu, Au, Al, Mg and Zn may at the same time be made to fill the hole. Thereafter, through heating, metal 1, and, in cases where metal 3 is additionally filled, metals 1 and 3 is/are allowed to infiltrate in a non-oxidizable atmosphere, so as to fill the gap of the packed powder. And also, the carbide of metal 2 is formed on the surface of the diamond grains, whereby the metal-diamond composite is formed within the hole and joined to the substrate. The powder may be molded in the hole by means of a high pressure press.

### (Fabrication example D)

Another method for fabricating the metal-diamond composite within the hole provided in the substrate will now be described below.
First of all, a mixed powder that comprises diamond grains, a powder of metal 1 composed of one or more element(s) selected from Ag, Cu, Au, Al, Mg and Zn, and a powder of metal 2 composed of one or more element(s) selected from Groups 4a, 5a and 6a is pressure-molded, whereby a temporary molded body in which the diamond grains and metal powders are distributed at a uniform density is obtained. Furthermore, a powder of metal 3, which is composed of one or more element(s) selected from Ag, Cu, Au, Al, Mg and Zn, is prepared separately.

Next, the powder of metal 3 and the temporary molded body are made to fill a hole provided in the substrate with the order of the powder of metal 3, the temporary molded body, the powder of metal 3. The substrate is then heated in a non-oxidizable atmosphere to allow metal 3 to infiltrate the temporary molded body, such that the gap in the temporary molded body is filled by metal 3 and the carbide of metal 2 is formed on the surface of the diamond grains, whereby the metal-diamond composite is formed within the hole and joined to the substrate. In this case, a press-molded body of metal powder 3 can also be used in place of the metal powder 3. The temporary molded body may be molded by a high pressure press.

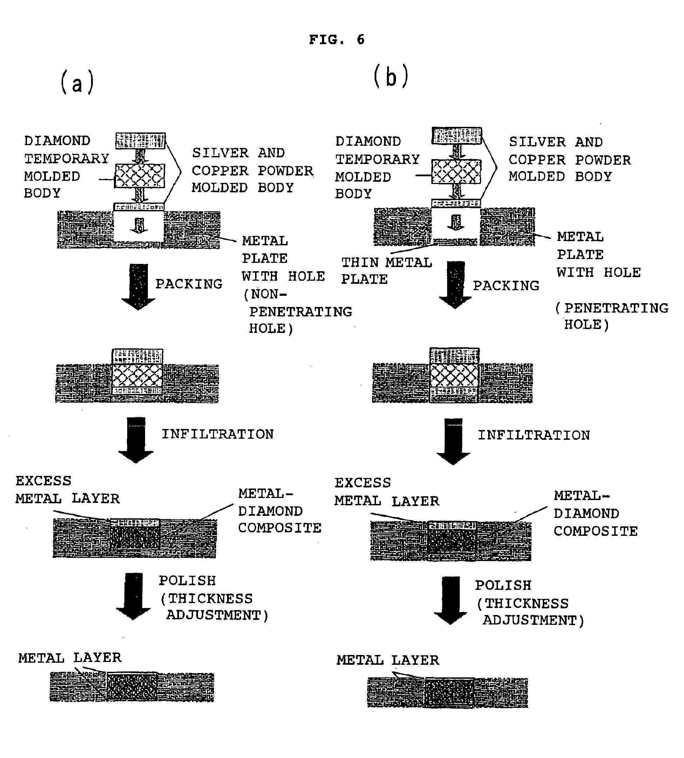

A conceptual view for this fabrication example is shown in Fig. 6.
Fig. 6(a) shows a case where a non-penetrating hole is made in a metal plate which is a substrate, and Fig. 6 (b) shows a case where a penetrating hole is made in the metal plate. When a penetrating hole is thus formed, a thin metal plate is laid out on the bottom of the hole. The diamond doesn't need to be machined entirely by leaving a metal layer on the upper and lower faces of the thin metal plate as per the illustration, which is beneficial in terms of cost. When a penetrating hole is formed, a cost reduction is possible because the metal substrate can be formed by pressing.

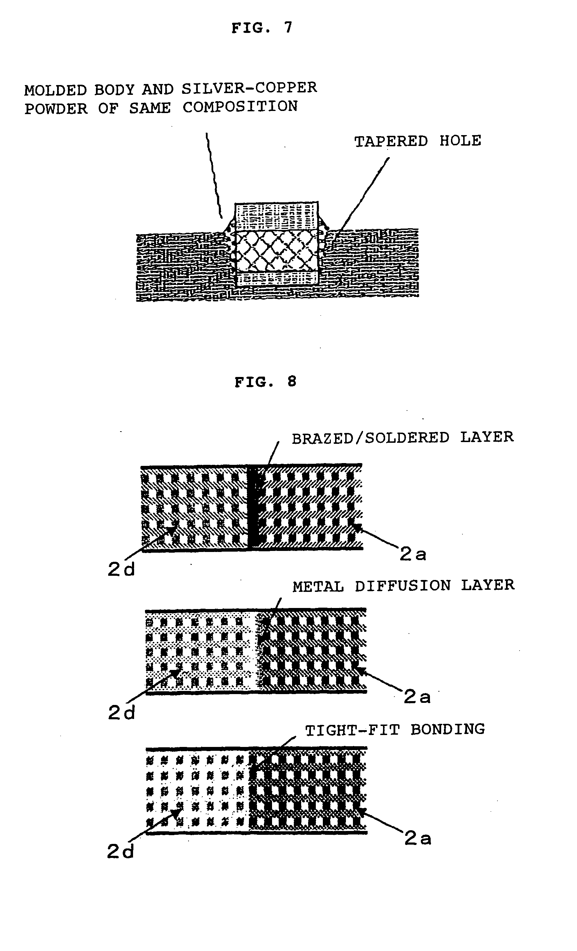

When fabrication example D is adopted, the hole provided in the substrate is preferably a tapered hole as shown in Fig. 7. By packing a powder of the same composition as the powder constituting the diamond temporary molded body into the gap between the hole and the diamond temporary molded body in the tapered hole, join defects arising from the gap due to the production accuracy of the hole and metal-diamond composite can be improved.

The joined state of a join section 2e between the metal-diamond composite and the metal portion of the substrate is shown in Fig. 8. Citable joining methods include brazing, a method involving diffusion of metals, and tight-fit bonding.

Although, in Fig. 1, the metal-diamond composite is exposed at the mounting space for a semiconductor chip or is formed as far as a position directly below the gold plated layer, a layer that is constituted only by the metal forming the metal-diamond composite may also lie close to the mounting face side or the lower face side. In this case, in comparison with a case where the metal-diamond composite is exposed, the surface roughness of the mounting space is improved, and hence this has the effect of compensating for the drop in the thermal conductivity arising from the non-exposure of the diamond grains.

In addition, when the semiconductor package is fixed by being screwed to an external electrical circuit via a screw mounting part 2b, the semiconductor package can be rigidly fixed by use of a metal or metal alloy part. Then, the semiconductor package can be rigidly bonded by being screwed to an external electrical circuit via the screw mounting part of the substrate, and the heat generated during operation of the semiconductor chip can be efficiently transferred from the substrate to the heat sink.

The gold plated layer is preferably formed by means of deposition on at least a portion of each surface of the substrate 2, the frame 3, and the input/output terminal 4. The gold plated layer preferably covers the whole of the copper and/or silver surface exposed at the metal-diamond composite surface, the joint for the input/output terminal of the frame, and the input/output terminal, because, this gold plated layer affords the function of suppressing corrosion caused by oxidation in the usage environment. Furthermore, when the semiconductor package is electrically connected to an external circuit, a wire bonding or ribbon bonding connection using solder and aluminum wire, gold wire, or a gold ribbon is possible. In addition, the gold plated layer functions as a so-called thermal conduction medium for the lateral transfer of the heat generated during operation of a semiconductor chip. Moreover, the gold plated layer functions as a so-called medium improving solderability for raising the solderability of brazing material when a member for joining the substrate and frame is assembled by means of brazing material such as gold (Au)-tin (Sn) and silver (Ag) brazing material.

When the airtightness of the inside of the semiconductor package is tested using helium (He), the gold plated layer effectively prevents a portion of the He from being trapped by the air holes in the metal-diamond composite. Thus, this gold plated layer is competent with respect to the inspection. In addition, because heat generated during operation of the semiconductor chip is transmitted along the gold plated layer via the join section (mounting space) in which a semiconductor chip is joined (mounted), the gold plated layer is able to bring about efficient diffusion from the whole inside of the semiconductor package to the whole of the outside surface of the package and then to the heat sink and the atmosphere.

The thickness of this gold plated layer is preferably 0.2 to 5 µm. When less than 0.2 µm, the effect that prevents the copper and/or silver exposed at the metal-diamond composite surface from oxidation is compromised by pin holes and so forth. In addition, when a semiconductor chip or an input/output terminal is connected by means of brazing material such as Au-Sn or Ag brazing material, the solderability of the raw material is readily damaged, the gold plated layer's function as a thermal conduction medium is compromised, and the airtightness reveals unstableness in the airtightness test for the inside of the semiconductor package. On the other hand, when the thickness of the gold plated layer exceeds 5 µm, the distortion caused by the thermal stress produced between the metal-diamond composite and the gold plated layer is large, meaning that the gold plated layer is readily detached. Such a thickness is also disadvantageous in cost.

The frame 3, whose shape in a planar view is substantially a square, is such that the four side walls of the frame 3 that surround the semiconductor chip may each be formed from separate individual pieces. That is, even when the individual pieces are joined together via brazing material such as silver brazing material, heat generated during operation of the semiconductor chip can be efficiently diffused as described above. Further, the individual pieces are not limited in number to four, it being possible to form a frame having two continuous side walls in which two individual pieces are joined by brazing material such as silver brazing material, a U-shaped frame having three continuous side walls in which a single individual piece is joined to the opening of the U-shape using brazing material, or a frame in which a single side wall is divided into two or more side walls is joined using brazing material.

The joint 3a for the input/output terminal is provided on the side or top of the frame to afford a function for keeping the airtightness of the inside of the semiconductor package and a function permitting high frequency signal inputs and outputs to be made between the semiconductor package and an external electrical circuit. The frame 3 is preferably formed from a ceramic material, and a ceramic material such as an alumina (Al₂O₃) ceramic or an aluminum nitride (AlN) ceramic material is suitably selected in accordance with characteristics such as the dielectric constant and the thermal expansion coefficient and so forth.

The joint 3a of the input/output terminal has a metallized layer formed to connect to the input/output terminal. The input/output terminal consists of a metal such as an Fe-Ni alloy or an Fe-Ni-Co alloy and is joined by brazing material or solder to the joint (metallized layer) formed on the side or top of the frame.

Therefore, the semiconductor package of the present invention furnishes a substrate 2, which has a mounting space 2c whereon the semiconductor chip is mounted and a screw mounting part 2b, and a frame 3, which surrounds the mounting space and has an joint 3a for connecting the input/output terminal on the side thereof. The substrate 2 is composed of a metal portion 2a, and a metal-diamond composite 2d, in which the matrix comprising diamond grains joined via a metal carbide is infiltrated with copper and/or silver. This semiconductor package also comprises an input/output terminal 4 that is connected to the joint via brazing material. The surface of the metal-diamond composite is preferably plated with gold.

A semiconductor device as a product is manufactured by providing the semiconductor package of the present invention; a semiconductor chip, which is mounted on and fixed to the mounting space of the semiconductor package and electrically connected to the input/output terminal; and a lid, which is joined to the upper face of the frame and seals the semiconductor chip.

More specifically, the semiconductor chip is bonded to the upper face of the mounting space via an adhesive such as glass, resin, brazing material and so forth, and the electrodes of the semiconductor chip are electrically connected to a predetermined input/output terminal via bonding wire. Thereafter, as a result of joining the lid to the upper face of the package by means of glass, resin, brazing material, seam welding, or the like, the semiconductor chip is hermetically housed within the semiconductor package comprising the substrate, frame, and input/output terminal. The semiconductor device is completed as a product by joining the lid to the upper face of the semiconductor package.

The present invention is not limited to or by the above embodiment, there being no obstacle of any kind to a variety of modifications within the scope of the present invention not departing from the purport thereof. For example, in a case where the semiconductor chip housed within the semiconductor package is an MMIC chip for wireless communications, or similar, a semiconductor device is produced by providing the semiconductor package with a power amplifier device and a substrate furnishing an antenna by means of thick film metallization on an Al₂O₃ ceramic substrate and so forth.

This wireless semiconductor device functions as a wireless signal transmitter by operating a wireless semiconductor chip by use of a high frequency signal from an external electrical circuit, for example, amplifying this signal by the power amplifier, and transmitting a wireless signal via the antenna, and hence the device can be employed in a large number of wireless communication fields and so forth.

Examples will be shown and the present invention described in more detail hereinbelow.

### Example 1

A metal-diamond composite which is molded with the dimensions 12×4×1.5 mm and composed of diamond grains with an average grain diameter of 60 µm covered with TiC, and of silver and copper and an alloy thereof laying between these diamond grains, was prepared, the thermal conductivity being 500 W/m·K or more and the thermal expansion coefficient being approximately 6.5×10⁻⁶/K. An oxygen free high conductivity copper plate with a thickness of 1.5mm, in which 12.1×4.1 mm holes were separately formed in a plurality at regular intervals and whose thermal expansion coefficient was approximately 17.0×10⁻⁶/K, was prepared. The metal-diamond composite was inserted into the holes in the oxygen free high conductivity copper plate and joined thereto by means of silver brazing. The oxygen free high conductivity copper plate was then cut to the dimensions 30×6 mm such that the metal-diamond composite laid at the center thereof. A through-hole with a diameter of 3.2 mm to be used for a screw attachment was formed in the two sides of the copper plate (this part is called as part 1). For the purpose of a comparison, an oxygen free high conductivity copper part with the dimensions 30×6×1.5 mm was also prepared and a through-hole with a diameter of 3.2 mm to be used for a screw attachment was formed in the two sides of the copper part (this part is called as part 2). Separately, a special alumina ceramic ring part (17×6×0.5 mm in size and formed with a 13x4 mm hole in the center, over whose entire lower face a thick film of tungsten is formed and whose upper face is formed with a thick film of tungsten with a width of 13 mm distributed in the middle of the longer sides thereof), and an input/output lead frame made of Fe-Ni-Co (trade name: Kovar) were prepared. Parts 1 and 2 and the tungsten thick film part of the ceramic ring were Ni-plated. The parts 1 and 2, the ceramic ring, and the lead frame were joined together by using silver brazing. The whole joined body was Ni/Au plated. An LDMOS (Laterally Diffused Metal Oxide Silicon, as below)-type high power transistor was soldered using AuGe within the ceramic ring and a connection was made to the lead frame via ribbon bonding, to produce the semiconductor device.

When the transistor was operated by supplying same with electric power, the chip surface temperature of the device using part 1 was lower at 15°C or more in comparison with the device using part 2. In addition, when a long endurance was tested, the life of this semiconductor chip was increased by 20% or more.

### Example 2

A metal-diamond composite which was molded with the dimensions 12×4×1.5 mm and composed of diamond grains with an average grain diameter of 60 µm covered with TiC, and of silver and copper and an alloy thereof laying between these diamond grains, was prepared, the thermal conductivity being 500 W/m·K or more and the thermal expansion coefficient being approximately 6.5×10⁻⁶/K. An oxygen free high conductivity copper plate with a thickness of 1.5 mm, in which 11.95x3.98 mm holes were separately formed in a plurality at regular intervals and whose thermal expansion coefficient was approximately 17.0×10⁻⁶/K, was prepared. The oxygen free high conductivity copper was previously heated at 500 °C in an non-oxidizable atmosphere, the metal-diamond composite was inserted into the holes that had expanded under thermal expansion, the copper plate was cooled, and the metal-diamond composite was thus joined by means of tight-fit bonding. The oxygen free high conductivity copper was then cut to the dimensions 30×6 mm such that the metal-diamond composite laid at the center thereof, and a through-hole with a diameter of 3.2 mm to be used for a screw attachment was formed in the two sides of the copper plate.

Similarly to Example 1, package form was finished by use of an alumina ceramic ring part and a Kovar (trade name) input/output lead frame. And, an LDMOS-type high power transistor was soldered using AuGe to the inside of the ceramic ring and connected to the lead frame by ribbon bonding, whereby a semiconductor device was produced.

As a result of operating the transistor by supplying same with electric power, the semiconductor device exhibited the same chip surface temperature as the semiconductor device of Example 1 in which the oxygen free high conductivity copper and metal-diamond composite were joined by silver brazing. Hence, also in a long endurance test, the same results were obtained for the life of the semiconductor chip.

### Example 3

A metal-diamond composite which was molded with the dimensions 12×4×1.4 mm and composed of diamond grains with an average grain diameter of 60 µm covered with TiC, and of silver and copper and an alloy thereof laying between these diamond grains, was prepared, the thermal conductivity being 500 W/m·K or more and the thermal expansion coefficient being approximately 6.5×10⁻⁶/K. An oxygen free high conductivity copper plate with a thickness of 1.5 mm , in which 12.5×4.5 mm holes were separately formed in a plurality at regular intervals and whose thermal expansion coefficient was approximately 17.0×10⁻⁶/K, was also prepared. The prepared metal-diamond composite and a powder of the metal (silver and copper) that constituted the metal-diamond composite were made to fill the holes in the oxygen free high conductivity copper plate so as to rise slightly above the copper plate. The plate was heated at approximately 1000°C in a non-oxidizable atmosphere. The metal powder thus softened and melted in the non-oxidizable atmosphere, joined to each the metal-diamond composite and the oxygen free high conductivity copper, and diffused, then the holes in the oxygen free high conductivity copper were completely packed. After the surface had been polished in order to remove the portion which rose above the plate, the oxygen free high conductivity copper was cut to the dimensions 30x6 mm such that the metal-diamond composite laid at the center thereof, and a through-hole with a diameter of 3.2 mm to be used for a screw attachment was formed in the two sides of the copper plate.

Similarly to Example 1, a package form was achieved by use of an alumina ceramic ring part and a Kovar (trade name) input/output lead frame. An LDMOS-type high power transistor was soldered using AuGe to the inside of the ceramic ring and connected to the lead frame by ribbon bonding, whereby a semiconductor device was produced.

As a result of operating the transistor by supplying same with electric power, the semiconductor device exhibited the same chip surface temperature as the semiconductor device of Example 1 in which the oxygen free high conductivity copper and metal-diamond composite were joined by silver brazing. Hence, also in a long endurance test, the same results were obtained for the life of the semiconductor chip.

### Example 4

An oxygen free high conductivity copper plate with a thickness of 1.5 mm, in which 12.5x4.5 mm holes were separately formed in a plurality at regular intervals and whose thermal expansion coefficient was approximately 17.0×10⁻⁶/K, was prepared. Diamond grains with a grain diameter on the order of 30 to 80 µm, silver powder, copper powder, and activated silver brazing (Ag-Cu-Ti) powder was agitated and mixed and then made to adequately fill the holes in the oxygen free high conductivity copper plate so as to rise thereabove. A fixing frame was disposed along the outer perimeter of the copper plate so that the copper plate did not extend under pressure during pressing. By pressing the copper plate from above by means of a high pressure press so that the surface pressure was approximately 800 MPa, the diamond grains and metal powder were packed at a uniform density within the holes in the copper plate. Thereafter, metal consisting of Ag and Cu was allowed to infiltrate the holes in a non-oxidizable atmosphere in order to fill the remaining air holes in the packing with the diamond grains and the metal, and at the same time, to increase the rigidity of the join to the metal by using Ti to form a carbide (TiC) around the diamond grains. After the surface had been polished in order to remove the portion which rose above the copper plate, the oxygen free high conductivity copper was cut to the dimensions 30×6 mm such that the metal-diamond composite laid at the center thereof, and a through-hole with a diameter of 3.2 mm to be used for a screw attachment was formed in the two sides of the copper plate.

Similarly to Example 1, a package form was finished by use of an alumina ceramic ring part and a Kovar (trade name) input/output lead frame. An LDMOS-type high power transistor was soldered using AuGe to the inside of the ceramic ring and connected to the lead frame by ribbon bonding, whereby a semiconductor device was produced.

As a result of operating the transistor by supplying same with electric power, the semiconductor device exhibited the same chip surface temperature as the semiconductor device of Example 1 in which the oxygen free high conductivity copper and metal-diamond composite were joined by silver brazing. Hence, also in a long endurance test, the same results were obtained for the life of the semiconductor chip.

### Example 5

An oxygen free high conductivity copper plate with a thickness of 2 mm, in which 12.5×4.5 mm, 1.5 mm-deep holes were separately formed in a plurality at regular intervals and whose thermal expansion coefficient was approximately 17.0×10⁻⁶/K, was prepared. Diamond grains with a grain diameter on the order of 30 to 80 µm, silver powder, copper powder, and activated silver brazing (Ag-Cu-Ti) powder was agitated and mixed and then made to adequately fill the holes in the oxygen free high conductivity copper plate so as to rise thereabove. A fixing frame was disposed along the outer perimeter of the copper plate so that the copper plate did not extend under pressure during pressing. By pressing the copper plate from above by a high pressure press so that the surface pressure was approximately 800 MPa, the diamond grains and metal powder were packed at a uniform density within the holes in the copper plate. Thereafter, metal consisting of Ag and Cu was allowed to infiltrate the holes in a non-oxidizable atmosphere in order to fill the remaining air holes in the packing with the diamond grains and the metal, and at the same time, to increase the rigidity of the join to the metal by using Ti to form a carbide (TiC) around the diamond grains. After the surface had been polished in order to remove the risen portion of the upper face and the reverse-side face had been polished in order to adjust the thickness to 1.5 mm, the oxygen free high conductivity copper was cut to the dimensions 30x6 mm such that the metal-diamond composite laid at the center thereof. A through-hole with a diameter of 3.2 mm to be used for a screw attachment was formed in the two sides of the copper plate.

Similarly to Example 1, a package form is achieved by use of an alumina ceramic ring part and a Kovar (trade name) input/output lead frame. An LDMOS-type high power transistor was soldered using AuGe to the inside of the ceramic ring and connected to the lead frame by ribbon bonding, whereby a semiconductor device was produced.

As a result of operating the transistor by supplying same with electric power, the semiconductor device exhibited the same chip surface temperature as the semiconductor device of Example 1 in which the oxygen free high conductivity copper and metal-diamond composite were joined by silver brazing. Hence, also in a long endurance test, the same results were obtained for the life of the semiconductor chip.

### Example 6

A Kovar (trade name) plate with a thickness of 2 mm, in which a plurality of 12.5×4.5 mm holes 1.4 mm-deep was separately formed at regular intervals, was prepared. Diamond grains with a grain diameter of 10 to 60 µm, silver powder, copper powder, and titanium powder were agitated and mixed. The mixture was then made to fill a die and pressure-molded at a surface pressure of approximately 800 MPa to prepare a temporary molded body with the dimensions 12.4×4.4×1.3 mm in which the diamond grains and the metal powder were distributed at a uniform density. A powder, in which silver powder and copper powder were mixed so that the weight ratio is 72 wt% and 28wt% respectively, was also prepared. The powder was made to fill a prepared alloy plate followed by the temporary molded body and then more powder again, and the alloy plate was then placed in an non-oxidizable atmosphere chamber at around 900°C. The plate thus obtained was formed as a result of a carbide (TiC) being formed around the diamond grains, and silver and copper being allowed to permeate between the grains as a substantially eutectic structure, thereby establishing a join with the alloy plate. After the upper and lower faces of the plate had been polished to establish a thickness of 1.5 mm, the alloy plate part was cut to the dimensions 30x6 mm such that the metal-diamond composite laid at the center thereof. A through-hole with a diameter of 3.2 mm to be used for a screw attachment was formed in the two sides of the plate.

Similarly to Example 1, a package form was finished by use of an alumina ceramic ring part and a Kovar (trade name) input/output lead frame. An LDMOS-type high power transistor was soldered using AuGe to the inside of the ceramic ring and connected to the lead frame by ribbon bonding, whereby a semiconductor device was produced.

As a result of operating the transistor by supplying same with electric power, the semiconductor device exhibited the same chip surface temperature as the semiconductor device of Example 1 in which the oxygen free high conductivity copper and metal-diamond composite were joined by silver brazing. Hence, also in a long endurance test, the same results were obtained for the life of the semiconductor chip.

### Example 7

An oxygen free high conductivity copper plate with a thickness of 2 mm, in which a plurality of 1.4 mm-deep tapered holes whose bottom measures 12.5×4.5 mm was separately formed at regular intervals, was prepared. Diamond grains with a grain diameter of 10 to 60 µm, silver powder, copper powder, and titanium powder were agitated and mixed. The mixture was then made to fill a die and pressure-molded at a surface pressure of approximately 800 MPa to prepare a temporary molded body with the dimensions 12.4×4.4×1.3 mm in which the diamond grains and the metal powder were distributed at a uniform density. Metal molded bodies, which were obtained by press-molding a powder, which was produced by mixing silver powder and copper powder so that the weight ratios were 72 wt% and 28wt% respectively, to establish a size of 12.4×4.4 mm and thicknesses of 0.5 mm and 2 mm, were also prepared. The 0.5 mm-thick metal molded body was made to fill the prepared oxygen free high conductivity copper plate, this plate then being filled by the temporary molded body that was composed of the diamond grains and metal powder, and then the 2-mm thick metal molded body. The powder was also made to fill the tapered part and the plate was then placed in a non-oxidizable atmosphere chamber at around 900 °C. The plate thus obtained was produced as a result of a carbide (TiC) being formed around the diamond grains, and silver and copper being allowed to permeate between the grains as a substantially eutectic structure, thereby joining the oxygen free high conductivity copper plate. After polishing the copper plate to an overall thickness of 1.5 mm so that about 20 µm of the lower face of the oxygen free high conductivity copper plate remained, the plate was cut to the dimensions 30x6 mm such that the metal-diamond composite laid at the center thereof. A through-hole with a diameter of 3.2 mm to be used for a screw attachment was formed in the two sides of the copper plate.

Similarly to Example 1, a package form was achieved by use of the alumina ceramic ring part on the side where the oxygen free high conductivity copper layer remained and a Kovar (trade name) input/output lead frame. An LDMOS-type high power transistor was soldered using AuGe to the inside of the ceramic ring and connected to the lead frame by ribbon bonding, whereby a semiconductor device was produced.

As a result of operating the transistor by supplying same with electric power, the semiconductor device exhibited the same chip surface temperature as the semiconductor device of Example 1 in which the oxygen free high conductivity copper and metal-diamond composite were joined by silver brazing. Hence, also in a long endurance test, the same results were obtained for the life of the semiconductor chip.

### Example 8

An oxygen free high conductivity copper plate with a thickness of 2 mm, in which a plurality of 1.4 mm-deep tapered holes whose bottom measured 12.5×4.5 mm was separately formed at regular intervals, was prepared. A mixed powder produced by agitating and mixing diamond grains with a grain diameter of 10 to 60 µm, silver powder, copper powder, and titanium powder (mixed grains 1), and a mixed powder produced by agitating and mixing diamond grains with a grain diameter of 300 to 450 µm, silver powder, copper powder, and titanium powder (mixed grains 2), were prepared.

First of all, mixed grains 1 were made to thinly fill a die and then a 5-mm high, 11×3 mm frame was gently placed onto the filled mixed grains 1. Mixed grains 2 were packed inside, while mixed grains 1 were packed between the die and the outside of the frame. The frame was then gently removed and mixed grains 1 were re-packed from above, whereupon the powders were pressure-molded at a surface pressure of approximately 800 MPa to prepare a temporary molded body with the dimensions 12.4×4.4×1.3 mm. The diamond grains and the metal powder were distributed at a fixed density in the temporary molded body. Metal molded bodies, which were obtained by press-molding a powder, which was produced by mixing silver powder and copper powder so that the weight ratios were 72 wt% and 28wt% respectively, to mold a 12.4×4.4 mm size and thicknesses of 0.5 mm and 2 mm respectively, were also prepared. The 0.5 mm-thick metal molded body, the temporary molded body that contained the diamond grains and metal powder, and the 2-mm thick metal molded body were made to fill the prepared oxygen free high conductivity copper plate in this order. The powder was also made to fill the tapered part and the plate was then placed in a non-oxidizable atmosphere chamber at around 900°C. The plate thus obtained was produced as a result of a carbide (TiC) being formed around the diamond grains, and silver and copper being allowed to permeate between the grains as a substantially eutectic structure, thereby joining the oxygen free high conductivity copper plate. After polishing the copper plate to an overall thickness of 1.5 mm so that about 20 µm of the lower face of the oxygen free high conductivity copper plate remained, the plate was cut to the dimensions 30x6 mm such that the metal-diamond composite laid at the center thereof. A through-hole with a diameter of 3.2 mm to be used for a screw attachment was formed in the two sides of the copper plate.

Similarly to Example 1, a package form was achieved by use of the alumina ceramic ring part on the side where the oxygen free high conductivity copper layer remained and a Kovar (trade name) input/output lead frame. An LDMOS-type high power transistor was soldered using AuGe to the inside of the ceramic ring and connected to the lead frame by ribbon bonding, whereby a semiconductor device was produced.

As a result of operating the transistor by supplying same with electric power, the semiconductor device exhibited the same chip surface temperature as the semiconductor device of Example 1 in which the oxygen free high conductivity copper and metal-diamond composite were joined by silver brazing. Hence, also in a long endurance test, the same results were obtained for the life of the semiconductor chip.

The present invention is a semiconductor package that has a substrate, whose upper face is provided with a mounting space whereon a semiconductor chip is mounted, and whose opposite sides are provided with a screw mounting part that is a through-hole or notch; a frame, which is provided on the upper face of the substrate so as to surround the mounting space and whose side or top has a joint for an input/output terminal; and an input/output terminal, which is connected to the joint, wherein at least a portion of the substrate below the semiconductor chip mounting space thereof comprising a metal-diamond composite that is produced as a result of a base matrix in which diamond grains are joined via a metal carbide being infiltrated with a metal containing copper and/or silver as the main component, and another part that includes the screw mounting part is composed of metal. Therefore, the semiconductor package can be rigidly bonded, by being screwed, to an external electrical circuit, and heat, which is generated during operation of a semiconductor chip, can be efficiently transferred within the substrate and frame and then radiated by the heat sink of the external electrical circuit and in the atmosphere, and so forth.

Furthermore, because at least a portion of the substrate, frame, and input/output terminal surface of the semiconductor package of the present invention is plated with gold, corrosion resulting from oxidation of the copper and/or silver exposed at the surface of the metal-diamond composite can be suppressed, and hence the semiconductor chip enclosed therein can be used stably over long periods.

Moreover, by providing the semiconductor device of the present invention with the semiconductor package of the present invention; a semiconductor chip, which is mounted on and fixed to the mounting space of the semiconductor package and electrically connected to the input/output terminal thereof; and a lid, which is joined to the upper face of the frame, it is possible to provide a highly reliable semiconductor device that employs the semiconductor package with the functions and effects described above.

## Claims

1. A package for housing semiconductor chip comprising:
a substrate, whose upper face is provided with a mounting space whereon a semiconductor chip is mounted, and whose opposite sides are provided with a screw mounting part that is a through-hole or notch, and at least a portion of the substrate below the mounting space comprising
a metal-diamond composite comprising diamond grains,
a metal carbide covering a surface of the diamond grains, and
a metal containing silver and/or copper as a main component and laying between the diamond grains by infiltrating therebetween, and
wherein, a remaining part that includes the screw mounting part consists of a metal;
a frame on the upper face of the substrate so as to surround the mounting space, the frame having a joint for an input/output terminal at a side or top thereof; and
an input/output terminal being connected to the joint.

2. A package for housing semiconductor chip according to claim 1, wherein at least a portion of a surface of said substrate comprising the metal and the metal-diamond composite, and/or a portion of a surface of said frame, and/or a portion of a surface of said input/output terminal is plated with gold.

3. A package for housing semiconductor chip according to claim 1 or 2, wherein the metal of the substrate, which comprises comprising the metal and the metal-diamond composite is a metal or a metal alloy containing at least one element selected from Cu, Fe, Mo, W, Ni, Co and Cr.

4. A package for housing semiconductor chip according to any of claims 1 to 3, wherein a thermal expansion coefficient of the metal of said substrate, which comprises the metal and the metal-diamond composite, is the same as or greater than a thermal expansion coefficient of the metal-diamond composite.

5. A package for housing semiconductor chip according to any of claims 1 to 4, wherein a method for joining said metal and said metal-diamond composite is brazing.

6. A package for housing semiconductor chip according to any of claims 1 to 4, wherein a method for joining said metal and said metal-diamond composite is a method involving diffusion of the metals.

7. A package for housing semiconductor chip according to any of claims 1 to 4, wherein a method for joining said metal and said metal-diamond composite is tight-fit bonding.

8. A package for housing semiconductor chip according to any of claims 1 to 7, wherein an average grain diameter of the diamond grains is 10 to 700 µm.

9. A package for housing semiconductor chip according to any of claims 1 to 8, wherein an average grain diameter of the diamond grains is 50 to 700 µm at a center of the metal-diamond composite and 10 to 60 µm at a circumference thereof.

10. A semiconductor device comprising:
the package for housing semiconductor chip according to any of claims 1 to 9;
a semiconductor chip being mounted on and fixed to the mounting space; and
a lid being joined to an upper face of the frame.

11. A method for fabricating a package for housing semiconductor chip comprising:
inserting a metal-diamond composite into part of a hole in a metal substrate provided with a hole, the metal-diamond composite comprising diamond grains whose surface is covered with a metal carbide and a metal containing silver and/or copper as a main component and the metal laying between the diamond grains by infiltrating therebetween; and
joining the metal substrate and the metal-diamond composite together to form a substrate;
providing a mounting space to mount a semiconductor chip on an upper face of the substrate;
providing a screw mounting part that is a through-hole or notch at opposite sides of the substrate; and
assembling the substrate, a frame to be on the upper face of the substrate so as to surround the mounting space and having a joint for an input/output terminal at a side or top thereof, and an input/output terminal to be connected to the joint.

12. A method for fabricating a package for housing semiconductor chip comprising:
filling diamond grains, a powder of a metal containing copper and/or silver as a main component and a powder of a metal used to form a carbide, into a hole in a metal substrate provided with a hole;
packing a mixture of the diamond grains and the metal powders so that the diamond grains and the metal powders are distributed at a uniform density;
heating the packed mixture so as to form a metal-composite in which a carbide covers a surface of the diamond grains, and to join the metal-diamond composite and the metal substrate together to form a substrate, by allowing the metal containing copper and/or silver as a main component to infiltrate a gap in the powders;
providing a mounting space to mount a semiconductor chip on an upper face of the substrate;
providing a screw mounting part that is a through-hole or notch at opposite sides of the substrate; and
assembling the substrate, a frame to be on the upper face of the substrate so as to surround the mounting space and having a joint for an input/output terminal at a side or top thereof, and an input/output terminal to be connected to the joint;

13. A method for fabricating a package for housing semiconductor chip comprising:
press-molding a diamond grains, a powder of a metal containing copper and/or silver as a main component and a powder of a metal used to form a carbide, so as to form a temporary molded body in which the diamond grains and the metal powders are distributed at a uniform density;
filling the temporary molded body into a hole in a metal substrate provided with a hole;
allowing the powder of a metal containing copper and/or silver as a main component to infiltrate the temporary molded body so as to form a metal-diamond composite in which a carbide covers a surface of the diamond grains, and to join the metal-diamond composite and the metal substrate together, for obtaining a substrate;
providing a mounting space to mount a semiconductor chip on an upper face of the substrate;
providing a screw mounting part that is a through-hole or notch at opposite sides of the substrate; and
assembling the substrate, a frame to be on the upper face of the substrate so as to surround the mounting space and having a joint for an input/output terminal at a side or top thereof, and an input/output terminal to be connected to the joint.

14. A method for fabricating a package for housing semiconductor chip according to claim 13, wherein the temporary molded body is sandwiched between a molded bodies of the powder of a metal containing copper and/or silver as a main component, and then the metal containing copper and/or silver as a main component is allowed to infiltrate the temporary molded body by heating.
